# FASCICULE DE BREVET EUROPEEN

(11) **EP 0 389 312 B1**
(45) Date de publication et mention de la délivrance du brevet: **04.01.1995**
(21) Numéro de dépôt: 90400441.3
(22) Date de dépôt: 19.02.1990
(51) Int. Cl.: G01R 31/04, H01R 43/20

(54) **Système pour vérifier le branchement d'extrémités de conducteurs dans un connecteur, et installation automatique de branchement équipée dudit système**
Einrichtung zum Verifizieren der Verbindungen von Leiterenden in einem Stecker sowie automatische Verbindungsvorrichtung unter Verwendung dieser Einrichtung
System to verify conductor end connections to a connector and automatic connection installation using said system

(30) Priorité: 28.02.1989 FR 8902591
(43) Date de publication de la demande: 26.09.1990
(73) Titulaire: EUROCOPTER FRANCE, F-13725 Marignane Cédex (FR)
(72) Inventeur: Cerda, Léon Germain, F-13620 Carry-le-Rouet (FR)
(74) Mandataire: Bonnetat, Christian

(56) Documents cités:
- EP-A- 0 194 104
- FR-A- 2 598 858
- GB-A- 2 170 962
- US-A- 4 162 126
- US-A- 4 727 637

## Description

### Système pour vérifier le branchement d'extrémités de conducteurs dans un connecteur, et installation automatique de branchement équipée dudit système.

La présente invention concerne un système pour vérifier le branchement d'extrémités de conducteurs électriques dans les bornes correspondantes d'un connecteur, ainsi qu'une installation automatique de branchement comportant ledit système.

De façon générale, un connecteur présente une pluralité de bornes constituées chacune d'un alésage traversant de part en part le connecteur, l'extrémité du connecteur à brancher étant introduite par la face arrière du connecteur. Pour que le branchement soit correct, il est nécessaire que l'extrémité du conducteur soit enfichée dans la borne appropriée et que l'extrémité du conducteur soit enfichée à fond dans ladite borne.

Jusqu'à présent, une telle vérification est effectuée visuellement par l'opérateur, ce qui constitue une perte de temps, et une source d'erreur, puisque l'exactitude de cette vérification dépend en fait de l'acuité visuelle de l'opérateur et/ou de son degré de fatigue.

L'opérateur peut être aidé, dans cette vérification, en dirigeant un faisceau lumineux ponctuel de façon qu'il traverse la borne dans laquelle un conducteur déterminé doit être enfiché. Cependant, une telle visée ne fournit qu'une information du type "tout ou rien", qui permet de déterminer qu'une extrémité du conducteur déterminé est enfichée dans la borne appropriée, mais non pas que le branchement est correct, c'est-à-dire, comme déjà indiqué, que l'extrémité du conducteur est enfichée à fond dans ladite borne.

La présente invention a pour but d'éviter ces inconvénients et elle concerne un système permettant non seulement de déterminer que l'extrémité d'un conducteur particulier est introduite dans la borne qui correspond à ce dernier, mais encore de vérifier que le positionnement de ladite extrémité est correct, en d'autres termes qu'elle est bien enfoncée "à fond" dans ladite borne. On évite ainsi les inconvénients des systèmes antérieurs fonctionnant par "tout ou rien".

A cette fin, selon l'invention, le système pour vérifier le branchement de premières extrémités de conducteurs électriques dans les bornes correspondantes d'un connecteur présentant une face arrière d'introduction desdites extrémités des conducteurs et une face avant, chacune desdites bornes étant constituée d'un alésage traversant de part en part le connecteur, est caractérisé en ce qu'il comprend des premiers moyens d'éclairage destinés à éclairer obliquement la face avant dudit connecteur, lesdits premiers moyens d'éclairage présentant une forme d'anneau ou de couronne dont la face intérieure d'éclairement est inclinée en étant orientée vers la face avant du connecteur en position montée sur celui-ci, et des moyens électroniques d'observation et de visualisation de ladite face avant, de sorte que les variations de contraste sur ladite face avant du connecteur permettent de déterminer qu'une extrémité de conducteur particulier est introduite dans la borne appropriée du connecteur et que le positionnement de ladite extrémité de conducteur est correct.

Ainsi, on détermine, sans risque d'erreur, que le branchement de chacun des conducteurs sur le connecteur est correct, et cela sans perte de temps pour l'opérateur.

On remarquera que le brevet EP-A-0194104 décrit un appareil pour l'inspection automatique de broches de connexion électriques, dans le but de rejeter les connecteurs comportant des broches défectueuses. Pour cela, le connecteur est disposé sous une caméra de télévision reliée à un circuit d'analyse qui décompose l'image fournie par la caméra et la compare à des tolérances prédéterminées.

Par ailleurs, le document US-A-4 162 126 décrit un appareil pour mettre en évidence des défauts de surface sur un objet, comportant des moyens d'illumination pour illuminer la surface à partir de deux directions symétriques, et un capteur comportant une caméra de télévision ou analogue pour détecter la lumière réfléchie depuis la surface de l'objet, de façon à analyser ainsi le défaut.

De préférence, dans le système conforme à la présente invention, lesdits moyens d'observation comprennent une caméra CCD (diodes à couplage de charges).

La présente invention concerne également une installation automatique de branchement de premières extrémités de conducteurs électriques dans les bornes correspondantes d'un connecteur, comportant un dispositif informatique de pilotage, remarquable en ce qu'elle comprend un système de vérification du branchement desdites premières extrémités tel que défini ci-dessus, piloté par ledit dispositif informatique.

Avantageusement, afin d'augmenter encore la fiabilité de ladite installation, celle-ci comprend des moyens mécaniques de maintien et de reconnaissance dudit connecteur.

En particulier, lesdits moyens mécaniques de maintien et de reconnaissance peuvent comprendre plusieurs pions de centrage susceptibles de se déplacer radialement par rapport audit connecteur, au moins un desdits pions de centrage étant destiné à coopérer avec un organe d'indexage, de forme correspondante, prévu sur ledit connecteur.

De préférence, chacun desdits pions de centrage est monté à l'extrémité libre d'un bras dont l'autre extrémité est reliée à une rampe hélicoïdale prévue sur un support pouvant tourner.

Selon une autre caractéristique de l'invention, l'installation peut comprendre des seconds moyens d'éclairage ponctuel susceptibles de se déplacer suivant un système de coordonnées Ox,Oy parallèlement à la face avant du connecteur de façon à éclairer une borne prédéterminée de ce dernier.

Avantageusement, l'installation comprend un lecteur de codes à barres pour l'identification des conducteurs électriques, et/ou une pluralité de logements pour regrouper les secondes extrémités des conducteurs électriques.

Les figures du dessin annexé feront bien comprendre comment l'invention peut être réalisée.

La figure 1 est une vue schématique en perspective de l'installation automatique de branchement de l'invention comportant le système de vérification de branchement de l'invention.

La figure 2 est une vue de côté en coupe partielle, à plus grande échelle, d'une partie de l'installation de la figure 1.

La figure 3 est une vue schématique de dessus des moyens mécaniques de maintien et de reconnaissance du connecteur, appartenant à l'installation de l'invention.

Les figures 4a et 4b montrent comment un connecteur peut être maintenu en position à l'aide des moyens de maintien de la figure 4.

La figure 5 montre schématiquement les liaisons du microordinateur de pilotage aux différents éléments de l'installation de l'invention.

La figure 6 illustre la mise en oeuvre des moyens d'éclairage oblique et des moyens d'observation de l'installation de l'invention.

La figure 7 est un détail d'un écran de visualisation.

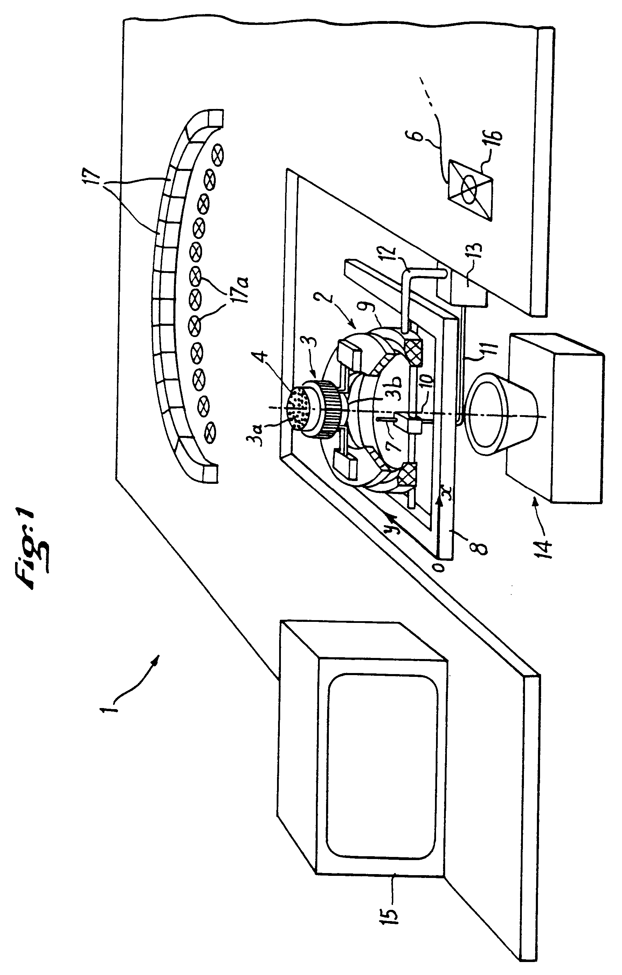

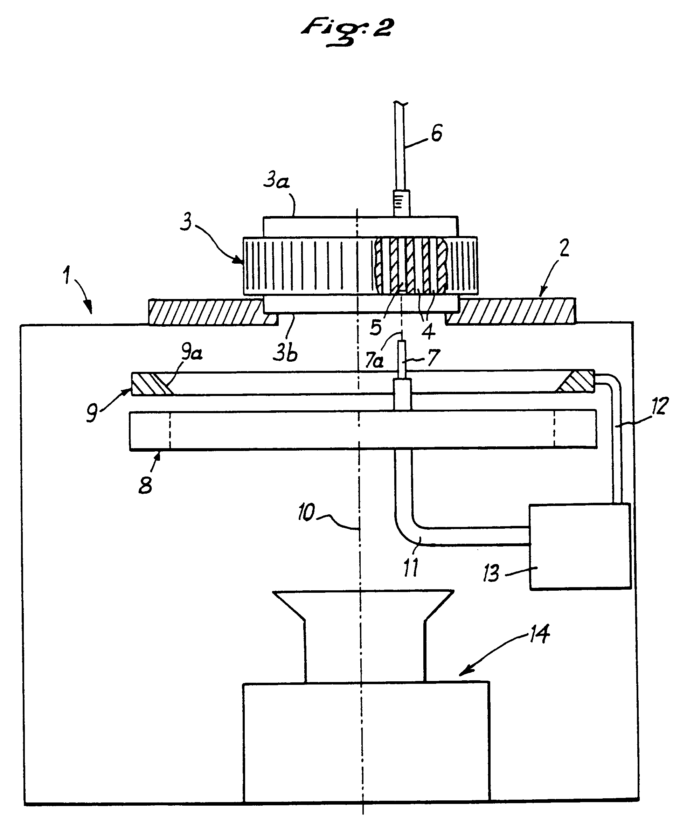

En se référant à la figure 1, l'installation 1 de l'invention comprend des moyens mécaniques de maintien et de reconnaissance 2 d'un connecteur 3 (rond dans cet exemple) décrits en détail par la suite. Comme on peut mieux le voir sur la figure 2, le connecteur 3 comporte une pluralité de bornes 4, chacune pour le branchement de l'extrémité 5 d'un conducteur électrique 6 introduite par la face arrière 3a du connecteur 3.

Une fibre optique 7, montée sur une table 8 de commande du déplacement de celle-ci suivant un système de coordonnées orthogonales Ox,Oy, peut se déplacer parallèlement à la face avant 3b du connecteur 3, de façon à éclairer une borne 4 choisie dans laquelle doit être introduite l'extrémité 5 du conducteur 6 approprié (figure 2).

Par ailleurs, sont prévus des moyens d'éclairage oblique 9 de la face avant 3b du connecteur 3. Ces moyens 9 présentent une forme d'anneau ou de couronne coaxiale à l'axe central 10 du connecteur 3 en position dans l'installation 1, la face d'éclairement 9a de l'anneau 9, intérieure à celui-ci, étant inclinée dans la direction de la face avant 3b du connecteur 3.

La fibre optique 7 et l'anneau 9 sont reliés, par les liaisons respectives 11 et 12, à un générateur de lumière 13 à intensité variable.

Sous la face avant 3b du connecteur 3, on prévoit de plus des moyens électroniques 14 d'observation et de visualisation de celle-ci, comme par exemple une caméra CCD (diodes à couplage de charges).

L'installation 1 comprend de plus un lecteur de codes à barres 16 permettant de lire le code 6a d'un conducteur 6 particulier, et une pluralité de logements 17 de conducteur, identifiés par des diodes électroluminescentes 17a, permettant de regrouper les extrémités, non branchées sur le connecteur 3 des conducteurs 6, ayant une même destination.

L'ensemble des éléments qui viennent d'être décrits de l'installation 1 est piloté par un microordinateur 15, d'une façon qui sera décrite par la suite.

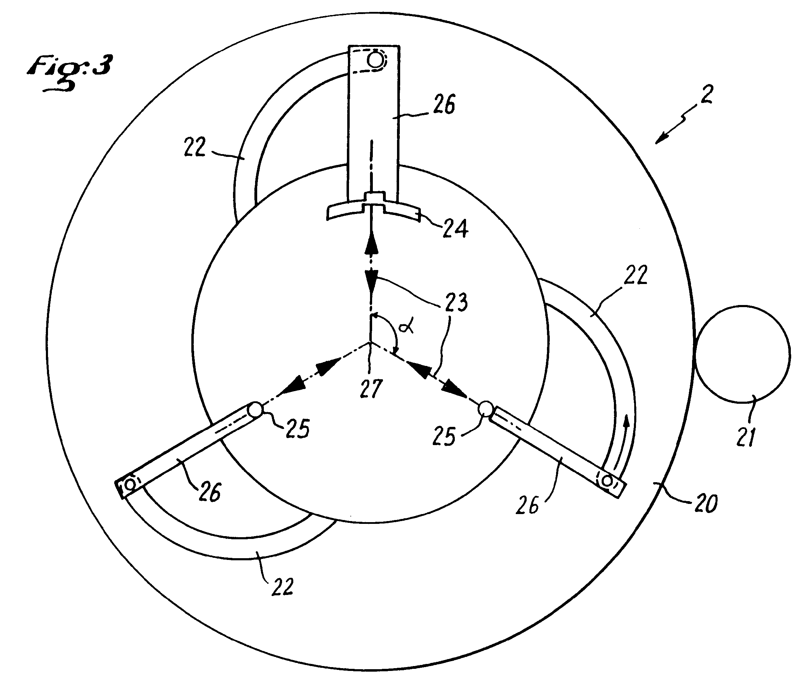

Comme montré schématiquement sur la figure 3, les moyens mécaniques 2 de maintien et de reconnaissance d'un connecteur comprennent, dans le cas d'un connecteur rond, un support 20 annulaire susceptible d'être entraîné en rotation autour de son axe 27 par un moteur pas-à-pas 21. Le support 20 comporte, à sa face supérieure, des rampes hélicoïdales 22 (trois dans le cas représenté) pour déplacer radialement (comme le montrent les doubles flèches 23) un ergot d'indexage 24 et deux pions de centrage 25 du connecteur, portés chacun à l'extrémité libre d'un bras 26 dont l'autre extrémité est reliée à la rampe 22 correspondante. L'ergot 24 et les pions 25 sont équiangulairement espacés d'un angles α = 120°.

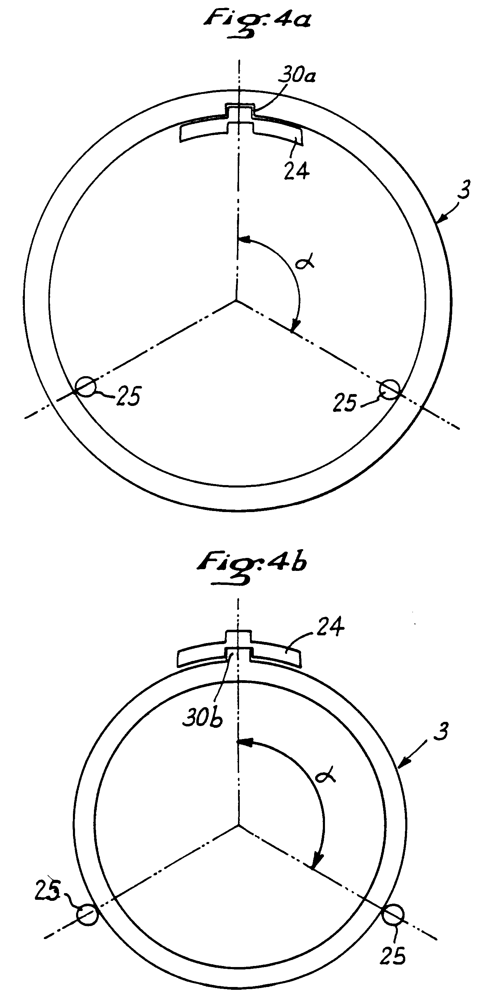

Selon le type du connecteur rond 3, deux cas peuvent se présenter, comme montré sur les figures 4a et 4b. L'ergot d'indexage 24 et les pions de centrage 25 peuvent être disposés intérieurement au connecteur 3 (figure 4a), l'ergot d'indexage 24 coopérant alors avec un organe creux 30a de forme correspondante ménagé intérieurement au connecteur 3, ou l'ergot d'indexage 24 et les pions de centrage 25 peuvent être disposés extérieurement au connecteur 3 (figure 4b), l'ergot d'indexage 24 coopérant alors avec un organe en saillie 30b de forme correspondante prévu extérieurement au connecteur 3.

Dans le cas de connecteurs rectangulaires, on peut fixer ceux-ci à l'aide d'un jeu de mâchoires, les connecteurs comportant également dans ce cas un organe d'indexage.

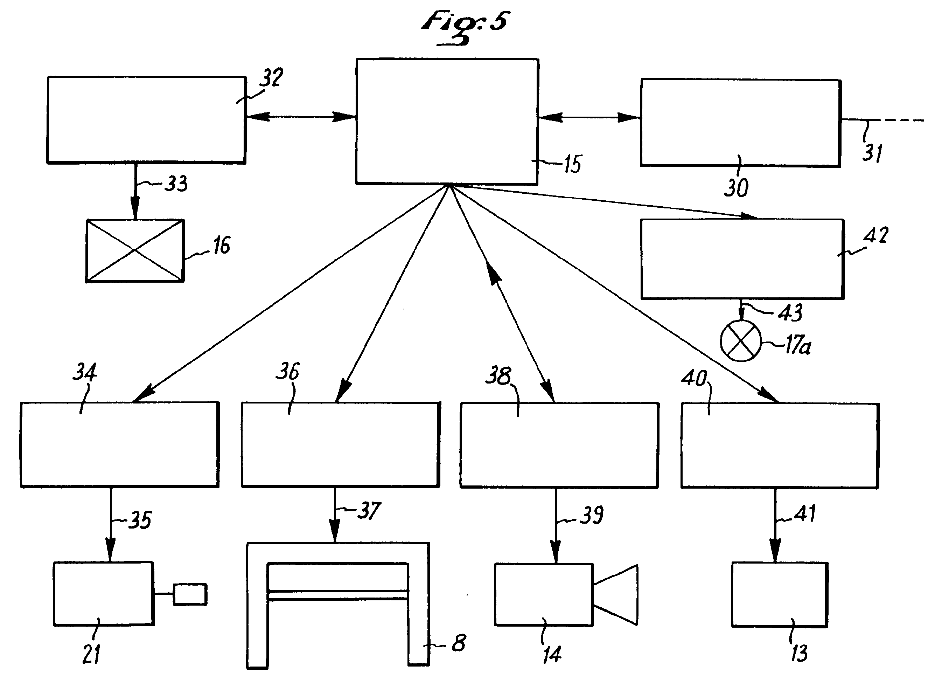

En se référant à la figure 5, le microordinateur 15 est relié, par la liaison 31 et par l'intermédiaire de l'interface 30, à un calculateur central (non représenté) contenant la banque de données techniques. Par ailleurs, le microordinateur 15 est relié :
- par la liaison 33 et par l'intermédiaire de l'interface 32, au lecteur de codes à barres 16,
- par la liaison 35 et par l'intermédiaire de l'interface 34, au moteur pas-à-pas 21,
- par la liaison 37 et par l'intermédiaire de l'interface 36, à la table 8 de déplacement de la fibre optique,
- par la liaison 39 et par l'intermédiaire de l'interface 38, à la caméra CCD 14,
- par la liaison 41 et par l'intermédiaire de l'interface 40, au générateur de lumière 13,
- par la liaison 43 et par l'intermédiaire de l'interface 42, aux diodes électroluminescentes 17a.

L'installation 1 de la présente invention est mise en oeuvre de la façon suivante.

Tout d'abord, le connecteur 3 est mis en place grâce aux moyens mécaniques 2 de maintien et de reconnaissance. A cet effet, selon le type de connecteur 3 utilisé, le microordinateur 15 pilote le moteur pas-à-pas 21 de façon à faire tourner le support 20 et, ainsi, grâce aux rampes hélicoïdales 22, à déplacer radialement l'ergot d'indexage 24 et les pions de centrage 25, de façon commandée, en adaptant la position de l'ergot 24 et des pions 25 au diamètre particulier du connecteur.

Le connecteur 3 est, de ce fait, solidement maintenu en position, de façon indexée, et, par ailleurs, ces moyens 2 jouent également un rôle de reconnaissance du connecteur 3, en ce que l'ergot 24 et les pions 25 "mesurent", pour ainsi dire, le diamètre du connecteur.

Une fois le connecteur 3 mis en place, chaque conducteur électrique 6 peut être identifié par lecture de son code à barres à l'aide du lecteur 16 relié au microordinateur 15. Ce dernier peut alors piloter le déplacement de la fibre optique 7 sur la table 8, de façon que le faisceau lumineux 7a issu de celle-ci désigne la borne 4 du connecteur 3 dans laquelle doit être enfichée l'extrémité 5 du conducteur 6 qui vient d'être identifié, de préférence à l'aide d'un outil spécifique. L'enfichage de l'extrémité 5 est réalisé par la face arrière 3a du connecteur 3, opposée à la face avant 3b en regard de la fibre optique 7.

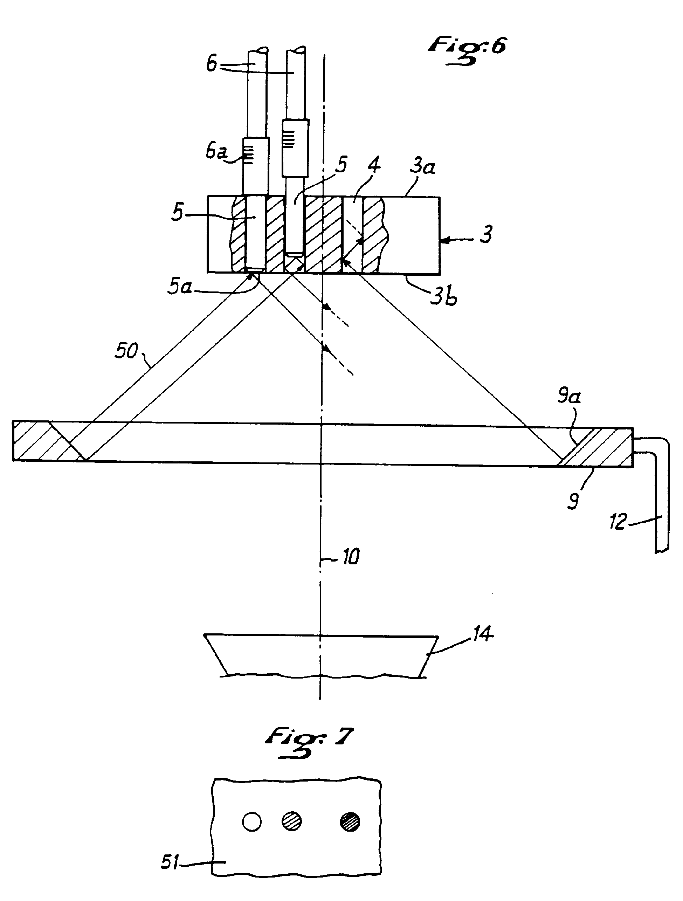

La figure 6 illustre la mise en oeuvre des moyens d'éclairage oblique 9 de la face avant 3b du connecteur 3 et des moyens d'observation 14. Ces derniers, comprenant notamment une caméra CCD, ont plusieurs fonctions :
- vérification de la géométrie du connecteur mis en place et de la disposition de ses bornes, en confirmant ainsi que le connecteur mis en place est bien celui à traiter,
- recalage automatique de l'origine de la table de déplacement de la fibre optique,
- contrôle du fait que l'extrémité du conducteur est enfichée dans la borne appropriée, et cela de façon correcte.

Cette dernière fonction sera maintenant expliquée plus en détail, toujours en référence à la figure 6 (à ce moment, bien entendu la table 8 de déplacement de la fibre optique 7 est en position de repos en dehors du champ de la caméra 14).

Le faisceau lumineux 50, issu de la face annulaire inclinée 9a de la couronne d'éclairage 9, en étant orientée vers la face avant 3b du connecteur 3, éclaire obliquement cette dernière et, en particulier, les alésages des bornes 4. Comme montré sur la figure 6, trois cas peuvent se présenter :
1) pour toutes les bornes 4 (dont une est représentée à droite sur la figure 6) dans lesquelles une extrémité 5 d'un conducteur électrique 6 n'a pas encore été enfichée, la lumière est "piégée" dans l'alésage, de sorte que celui-ci apparaît sombre pour la caméra 14, comme montré sur le détail 51 d'un écran de visualisation de la figure 7,
2) si l'extrémité 5 du conducteur 6 est parfaitement enfichée dans la borne 4 (à gauche sur la figure 6), la lumière 50 est réfléchie par la face d'extrémité 5a du conducteur 6, et l'"alésage" apparaît clair sur l'écran 51,
3) dans le cas où l'extrémité 5 du conducteur 6 n'est pas correctement enfichée dans la borne 4 (au milieu sur la figure 6), l'alésage présente, pour la caméra 14, une certaine nuance de gris selon que l'extrémité 5 est enfichée plus ou moins profondément dans la borne 4.

Ainsi, des variations de contraste, observées par la caméra 14 et lues sur l'écran 51, permettent de déterminer quelle(s) borne(s) est/sont munie(s) d'un conducteur et si l'enfichage pour chacune des bornes est correct.

De plus, les extrémités non branchées des conducteurs 6 peuvent être regroupées, selon leur destination, dans les logements 17 identifiés, chacun, par une diode électroluminescente 17a, les diodes étant commandées par le microordinateur 15.

## Revendications

1. Système pour vérifier le branchement de premières extrémités de conducteurs électriques dans les bornes correspondantes d'un connecteur présentant une face arrière d'introduction desdites extrémités des conducteurs et une face avant, chacune desdites bornes étant constituée d'un alésage traversant de part en part le connecteur,
caractérisé en ce qu'il comprend des premiers moyens d'éclairage (9) destinés à éclairer obliquement la face avant (3b) dudit connecteur (3), lesdits premiers moyens d'éclairage présentant une forme d'anneau ou de couronne (9) dont la face intérieure d'éclairement (9a) est inclinée en étant orientée vers la face avant (3b) du connecteur (3) en position montée de celui-ci, et des moyens électroniques (14) d'observation et de visualisation de ladite face avant (3b), de sorte que les variations de contraste sur ladite face avant (3b) du connecteur (3) permettent de déterminer qu'une extrémité (5) de conducteur particulier (6) est introduite dans la borne (4) appropriée du connecteur (3) et que le positionnement de ladite extrémité de conducteur (5) est correct.

2. Système selon la revendication 1,
caractérisé en ce que lesdits moyens d'observation comprennent une caméra CCD (diodes à couplage de charges) (14).

3. Installation automatique de branchement de premières extrémités de conducteurs électriques dans les bornes correspondantes d'un connecteur, comportant un dispositif informatique de pilotage,
caractérisée en ce qu'elle comprend un système de vérification du branchement desdites premières extrémités selon l'une des revendications 1 ou 2, piloté par ledit dispositif informatique (15).

4. Installation selon la revendication 3,
caractérisée en ce qu'elle comprend des moyens mécaniques (2) de maintien et de reconnaissance dudit connecteur.

5. Installation selon la revendication 4,
caractérisée en ce que lesdits moyens mécaniques (2) de maintien et de reconnaissance comprennent plusieurs pions de centrage (24,25) susceptibles de se déplacer radialement par rapport audit connecteur (3), au moins un (24) desdits pions de centrage étant destiné à coopérer avec un organe d'indexage (30a,30b), de forme correspondante, prévu sur ledit connecteur (3).

6. Installation selon la revendication 5,
caractérisée en ce que chacun desdits pions de centrage (24,25) est monté à l'extrémité libre d'un bras (26) dont l'autre extrémité est reliée à une rampe hélicoïdale (22) prévue sur un support (20) pouvant tourner.

7. Installation selon l'une quelconque des revendications 3 à 6,
caractérisée en ce qu'elle comprend des seconds moyens (7) d'éclairage ponctuel susceptibles de se déplacer suivant un système de coordonnées Ox,Oy parallèlement à la face avant (3b) du connecteur (3) de façon à éclairer une borne (4) prédéterminée de ce dernier.

8. Installation selon l'une quelconque des revendications 3 à 7,
caractérisée en ce qu'elle comprend un lecteur (16) de codes à barres pour l'identification des conducteurs électriques (6).

9. Installation selon l'une quelconque des revendications 3 à 8,
caractérisée en ce qu'elle comprend une pluralité de logements (17) pour regrouper les secondes extrémités des conducteurs électriques.

## Patentansprüche

1. System zur Überprüfung des Anschlusses erster Enden elektrischer Leiter in den entsprechenden Klemmen eines Steckverbinders mit einer Rückseite zur Einführung der Leiterenden und einer Vorderseite, wobei jede Klemme aus einer durchgehend durch den Steckverbinder verlaufenden Bohrung besteht,
dadurch gekennzeichnet, daß es erste Beleuchtungsmittel (9) zur Schräglichtbeleuchtung der Vorderseite (3b) des Steckverbinders (3), wobei die ersten Beleuchtungsmittel die Form eines Ringes oder Kranzes (9) haben, dessen innere Beleuchtungsseite (9a) nach der Vorderseite (3b) des Steckverbinders (3), wenn dieser montiert ist, geneigt ist, und elektronische Mittel (14) zur Beobachtung und Sichtbarmachung der Vorderseite (3b) hat, so daß durch Kontraständerungen an der Vorderseite (3b) des Steckverbinders (3) bestimmt werden kann, ob ein Ende (5) eines speziellen Leiters (6) in die geeignete Klemme (4) des Steckverbinders (3) eingeführt und die Positionierung des Leiterendes (5) richtig ist.

2. System nach Anspruch 1,
dadurch gekennzeichnet, daß die Beobachtungsmittel eine CCD-Kamera (ladungsgekoppelte Dioden) (14) haben.

3. Automatische Anlage zum Anschluß erster Enden elektrischer Leiter in den entsprechenden Klemmen eines Steckverbinders mit einer Informatikvorrichtung zur Steuerung,
dadurch gekennzeichnet, daß sie ein erstes System zur Überprüfung des Anschlusses der ersten Enden nach einem der Ansprüche 1 oder 2 umfaßt, das durch die Informatikvorrichtung (15) gesteuert wird.

4. Anlage nach Anspruch 3,
dadurch gekennzeichnet, daß sie mechanische Mittel (2) umfaßt, mit denen der Steckverbinder gehalten und erkannt werden kann.

5. Anlage nach Anspruch 4,
dadurch gekennzeichnet, daß die mechanischen Halte- und Erkennungsmittel (2) mehrere Zentrierstifte (24,25) haben, die radial gegenüber dem Steckverbinder (3) verschoben werden können, wobei mindestens einer (24) der Zentrierstifte mit einem Verriegelungsorgan (30a,30b) geeigneter Form am Steckverbinder (3) zusammenwirken soll.

6. Anlage nach Anspruch 5,
dadurch gekennzeichnet, daß jeder der Zentrierstifte (24,25) am freien Ende eines Arms (26) angebracht ist, dessen anderes Ende mit einer spiralförmigen Steigung (22) an einer drehbaren Unterlage (20) verbunden ist.

7. Anlage nach einem der Ansprüche 3 bis 6,
dadurch gekennzeichnet, daß sie zweite Mittel (7) zur punktförmigen Beleuchtung hat, die entsprechend einem Koordinatensystem Ox,Oy parallel zur Vorderseite (3b) des Steckverbinders (3) verschoben werden können, so daß eine vorbestimmte Klemme (4) desselben beleuchtet wird.

8. Anlage nach einem der Ansprüche 3 bis 7,
dadurch gekennzeichnet, daß sie einen Strichcodeleser (16) zur Identifizierung der elektrischen Leiter (6) hat.

9. Anlage nach einem der Ansprüche 3 bis 8, dadurch gekennzeichnet, daß sie eine Vielzahl von Lagerungen (17) zur Zusammenfassung der zweiten Enden der elektrischen Leiter hat.

## Claims

1. System for verifying the connecting of first ends of electrical conductors into the corresponding terminals of a connector having a rear face for introducing the said ends of the conductors and a front face, each of the said terminals consisting of a bore passing right through the connector,
characterized in that it comprises first illuminating means (9) intended for illuminating obliquely the front face (3b) of the said connector (3), the said first illuminating means having a ring or annulus shape (9), the inside illumination face (9a) of which is inclined while being oriented towards the front face (3b) of the connector (3) in the fitted position of the latter, and electronic means (14) of observation and display of the said front face (3b), such that the variations in contrast over the said front face (3b) of the connector (3) make it possible to determine that one end (5) of the particular conductor (6) has been introduced into the appropriate terminal (4) of the connector (3) and that the positioning of the said conductor end (5) is correct.

2. System according to Claim 1,
characterized in that the said means of observation comprise a CCD (charge coupled diode) camera (14).

3. Automatic installation for connecting first ends of electrical conductors into the corresponding terminals of a connector, including a computerized operating device,
characterized in that it comprises a system for verification of the connecting of the said first ends according to one of Claims 1 or 2, operated by the said computerized device (15).

4. Installation according to Claim 3,
characterized in that it comprises mechanical means (2) for holding and recognizing of the said connector.

5. Installation according to Claim 4,
characterized in that the said mechanical means (2) for holding and recognizing comprise several centring pegs (24, 25) capable of moving radially with respect to the said connector (3), at least one (24) of the said centring pegs being intended to cooperate with an indexing member (30a, 30b), of corresponding shape, provided on the said connector (3).

6. Installation according to Claim 5,
characterized in that each of the said centring pegs (24, 25) is fitted to the free end of an arm (26), the other end of which is linked to a helical ramp (22) provided on a support (20) able to rotate.

7. Installation according to any one of Claims 3 to 6,
characterized in that it comprises second, pointwise illuminating means (7) capable of moving in a system of coordinates Ox,Oy parallel to the front face (3b) of the connector (3) so as to illuminate a predetermined terminal (4) of the latter.

8. Installation according to any one of Claims 3 to 7,
characterized in that it comprises a bar-code reader (16) for identification of the electrical conductors (6).

9. Installation according to any one of Claims 3 to 8,
characterized in that it comprises a plurality of housings (17) for grouping together the second ends of the electrical conductors.
